Europäisches Patentamt

European Patent Office

Office européen des brevets

(19)

(11)　**EP 0 785 454 A1**

(12)　**EUROPEAN PATENT APPLICATION**

(43) Date of publication:
　　23.07.1997　Bulletin 1997/30

(21) Application number: 97100469.2

(22) Date of filing: 14.01.1997

(51) Int. Cl.$^6$: **G02F 1/00**, G02F 1/09,
　　H01F 10/08, H01F 10/24,
　　G01R 33/032

(84) Designated Contracting States:
　　**DE FR GB**

(30) Priority: **17.01.1996 JP 5796/96**

(71) Applicant: **MITSUBISHI GAS CHEMICAL
　　COMPANY, INC.
　　Tokyo, 100 (JP)**

(72) Inventors:
　• **Shirai, Kazushi,
　　c/o Mitsubishi Gas Chem.Co.Inc.
　　Katsushika-ku, Tokyo 125 (JP)**
　• **Takeda, Norio,
　　c/o Mitsubishi Gas Chem.Co.Inc.
　　Katsushika-ku, Tokyo 125 (JP)**

(74) Representative: **KUHNEN, WACKER & PARTNER
　　Alois-Steinecker-Strasse 22
　　85354 Freising (DE)**

(54)　**Faraday rotator for magneto-optic sensors**

(57)　　A Faraday rotator (1) includes two types of rare earth iron garnet single crystal films (layers 1 and 2); a main garnet film and an auxiliary garnet film. The main garnet film has a low saturation magnetization and the auxiliary film has a high saturation magnetization. The two garnet films are formed one over the other by the liquid phase epitaxy. As an external magnetic field strength is increased, the main garnet film is saturated but the auxiliary garnet film is not saturated yet due to its high saturation magnetization. When the external magnetic field is removed, the auxiliary garnet film which has not been saturated serves as a starting point or "nucleation" by which the magnetically saturated main garnet film can enter its non-saturation region showing a much decreased hysteresis.

**FIG.8**

EP 0 785 454 A1

**Description**

BACKGROUND OF THE INVENTION

TECHNICAL FIELD OF THE INVENTION

This invention relates to a rare earth iron garnet single crystal film which has a low saturation magnetization and a high sensitivity to magnetic fields. Specifically, this invention relates to a method of converting a rare earth iron garnet single crystal film, which despite its very low saturation magnetization has a high magnetic hysteresis, to a material suitable as a Faraday rotator for use with a magnetic sensor by combining it with a rare earth iron garnet single crystal film having a high saturation magnetization.

DESCRIPTION OF RELATED ART

In recent years, optical switches using bismuth-substituted rare earth iron garnet single crystal films having a large Faraday effect (wherein a part of the rare earths in the film are substituted by bismuth), and devices known as magneto-optical sensors, known also as electro-optical sensors or optical rotation sensors, have been appearing on the market one after another. Research is therefore being intensively carried out to develop bismuth-substituted rare earth iron garnet single crystal films suited for this application.

The Faraday effect is a type of magneto-optical effect wherein the plane of polarization of light is rotated when the light is transmitted through materials. Faraday elements (Faraday rotators) are formed of, for example, rare earth iron garnet single crystal films and show such effect.

In general, the rotation angle of the plane of polarization in a Faraday rotator is referred to as the Faraday rotation angle, and this increases in proportion to the strength of the external magnetic field applied to the Faraday element. The above description of Faraday rotation angle applies to feeble magnetism materials such as lead glass, but it is not always suitable to describe the Faraday rotation angle of rare earth iron garnet single crystal films which are ferromagnetic materials. This is due to the fact that rare earth iron garnet single crystal films are multi-domain materials comprising a plurality of magnetic domains.

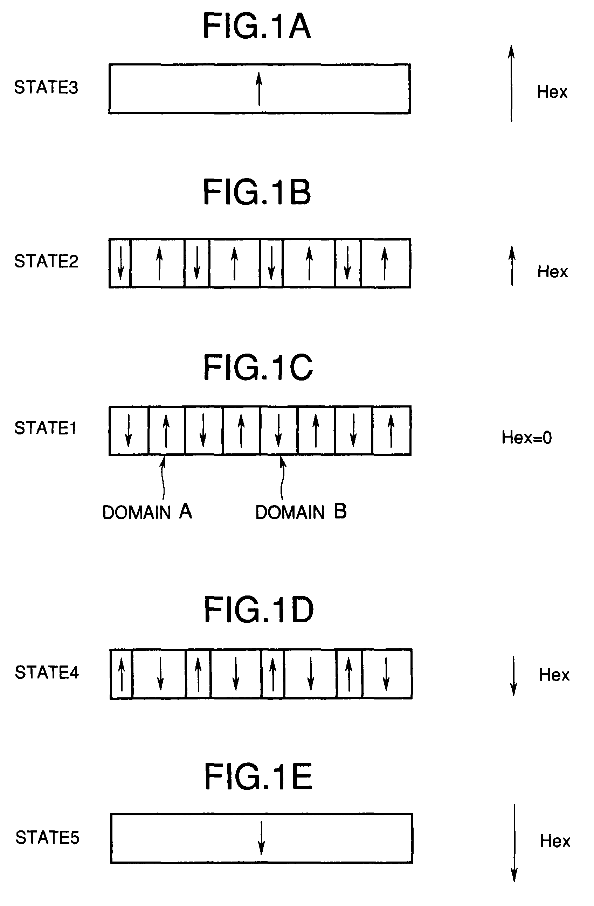

A description will be given of the variation of Faraday rotation angle and change of multi-domain structure relative to external magnetic field intensity in rare earth iron garnet single crystal films (including bismuth-substituted rare earth iron garnet single crystal films). Figs. 1A-1E show the change of magnetic domain structure of a rare earth iron garnet single crystal film corresponding to an external magnetic field.

State 1 of Fig. 1C shows a cross section of a rare earth iron garnet single crystal film, and magnetic domains ranging from a width of several microns to several tens of microns. Magnetic domains A which are magnetized in an upward direction are arranged in alternation with magnetic domains B which are magnetized in a downward direction.

The magnetic domains have different sign, however they have a Faraday rotation angle of identical value.

For the sake of simplicity, if the magnetization of a magnetic domain A is +M and its Faraday rotation angle is $+\theta f$, the magnetization of a magnetic domain B will be -M and its Faraday rotation angle is $-\theta f$. Again for the sake of convenience, assume that a positive Faraday rotation angle indicates a right-handed rotation of the plane of polarization, and a negative Faraday rotation angle indicates a left-handed rotation of the plane of polarization. Further, in the description below, the magnetization of the whole material (= rare earth iron garnet single crystal film) will be referred to as "magnetization" or "Mt", and Faraday rotation angle will be referred to as "Faraday rotation angle" or "$\theta t$".

In Fig. 1C, state 1 shows the case when no external magnetic field is applied. When an upward magnetic field is applied, the magnetic domain structure changes from state 1 in Fig. 1C to state 2 in Fig. 1B. Specifically, there is an increase of area occupied the domains A, of which the direction of magnetization is the same as that of the external field (taken as positive). As the strength of the external magnetic field is increased, the domains B finally disappear and a single direction of magnetization remains. This is the magnetically saturated state. When the external magnetic field is in a downward direction, the material passes via state 4 in Fig. 1D to reach state 5 in Fig. 1E.

The "magnetization" of the rare earth iron garnet single crystal film in state 3 in Fig. 1A is Mt = +M , and its Faraday rotation angle $\theta f$ is equal to the Faraday rotation angle $+\theta f$ of the domain A, i.e., $\theta t = +\theta f$ . In state 5, Mt = -M and $\theta t = -\theta f$ .

In state 2 or state 4, where both the domains A and B are present together, from the volume proportion Va of the domain A, the magnetization Mt of the whole rare earth iron garnet single crystal film may be expressed by the following equation (1):

$$Mt = +M \times Va + (-M) \times (1-Va) \qquad (1)$$

However, in state 1, 2 or 4, where both the domains A and B are present together, i.e. the multi-domain state, what kind of equation would express the Faraday rotation angle of the whole film?

A detailed discussion will be left to the Journal of Magnetic society of Japan, vol. 14 648-652 (1990) by Tanazawa et al, or the Transactions of the Institute of Electronics, Information and Communication Engineers, MR89-53 (1990), however the "Faraday rotation angle" cannot be uniquely determined and depends on the method used to measure it.

According to the usual method of measuring Faraday rotation angle, i.e., the method where linearly polarized light is used, the transmitted light is received by an analyzer, the analyzer is rotated and the rotation position of the analyzer is found where the intensity of the light transmitted by the analyser is a minimum, "θt" is given in terms of the saturation magnetization Ms of the material, as follows:

$$\theta t = \tan^{-1}\{(Mt/Ms)\tan\theta f\} \qquad (2)$$

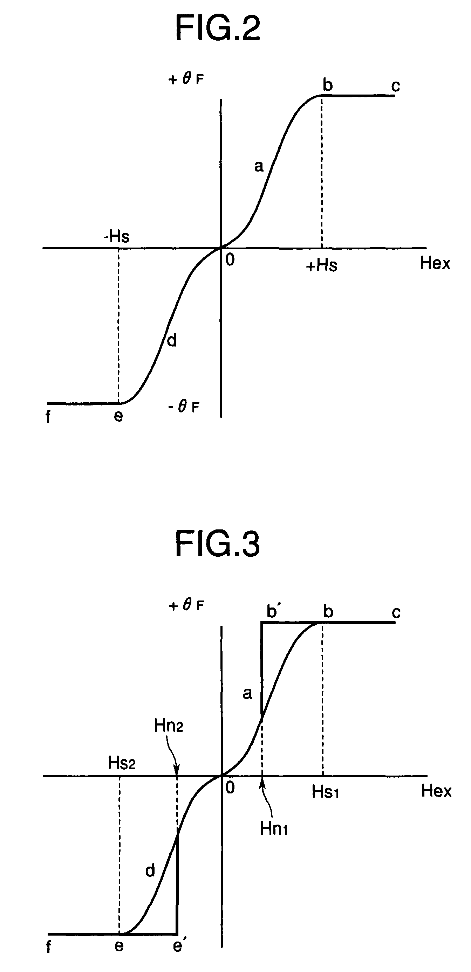

From equation (1), Mt varies according to the intensity of the external magnetic field, and θt varies as Mt varies. The relation between θt and the external field exhibits the behavior as shown in Fig. 2, but it should be noted that even for the same material, the contour of the curve changes depending on the magnitude of θf. In other words, for a multi-domain structure, the Faraday rotation angle of the whole material in the true sense of the word cannot be defined except in the saturated state, and is only an apparent value in other states.

Consequently, in a multi-domain structure such as that of a rare earth iron garnet single crystal film (including a bismuth-substituted rare earth iron garnet single crystal film), the Faraday rotation angle measured is an apparent value.

However the Faraday rotation angle may be observed as shown in Fig. 2 for a certain value of θf, and may be considered to reflect the magnetic domain structure. Herein, therefore, the variation of the apparent Faraday rotation angle, or "Faraday loop", of a rare earth iron garnet single crystal film relative to the external magnetic field will be described based on Fig. 2.

In Fig. 2, the apparent Faraday rotation angle ⊖F of a Faraday rotator is "0" when no external magnetic field Hex is applied, i.e., the Faraday rotation angle is situated at the origin o. This is state 1 of Fig. 1C. When the external field Hex is gradually increased, the apparent Faraday rotation angle ⊖F approaches the value for saturation magnetization via the route a or d (path o-a-b or path o-d-e). This state corresponds to state 2 of Fig. 1B or state 4 of Fig. 1D.

When the external field Hex reaches a certain intensity "Hs", the "Faraday rotation angle ⊖F" has a saturation value (saturation field b or e). If the external field Hex is then further increased, there is merely a shift in the field from b to c or from e to f, and the "Faraday rotation angle ⊖F" does not change. This state corresponds to state 3 in Fig. 1A or state 5 in Fig. 1E.

When the external magnetic field is gradually weakened, a reverse path, i.e., c-b-a-o or f-e-d-o is followed, and finally the angle returns to the origin where there is no influence of an external magnetic field.

Optical switches and magnetic sensors are examples of devices which use the magnetic field dependence of the state change of magnetic domains.

Optical switches function by having a field generator generate a field at or above the saturation points b and e, and switch between them. Electro-optical sensors detect magnetic fields by detecting a difference between apparent Faraday rotation angles (or a change of domain structure) at the origin o and the saturation point b as a light intensity. Magneto-optical sensors which are rotation sensors detect field strength by detecting a difference of Faraday rotation angle (in other words, a change of domain structure) at the origin o, the saturation point b or the saturation point e as a light intensity. Alternatively, they detect a difference of apparent Faraday rotation angle (or a change of domain structure) at a point a on the way to b, or at a point d on the way to e as a light intensity.

In a tachometer using a magneto-optical sensor, i.e., a tachometer using an optical signal, a permanent magnet is fitted to a rotating device (Applied Optics, Vol. 28, No. 11, page 1992 (1989)), and a magneto-optical sensor comprising a bismuth-substituted rare earth iron garnet crystal is disposed in an area affected by the field generated by this permanent magnet. As the rotating device rotates, the magneto-optical sensor and permanent magnet alternately approach and separate, and a difference appears in the field intensity applied to the Faraday rotator when the permanent magnet approaches and separates.

In other words, the domain structure changes due to the rotation of the permanent magnet, and the light intensity transmitted by an analyzer varies. The rotational speed of the magnet can be interpreted as a light intensity variation.

When the distance between the magnet and sensor head increases, the magnet's field becomes weaker. Therefore to increase the sensitivity and precision of the tachometer using the Faraday effect, either a more powerful permanent magnet must be used to compensate for the weakening of the field, or a sensor head must be chosen that still functions correctly in a weak field and the distance between the magnet and sensor head must be made shorter.

Replacing the permanent magnet by a more powerful magnet is not only economically disadvantageous. The magnet may also be larger so that there are restrictions on installation space, or the distance between the magnet and sensor head may increase so that no actual improvement is obtained. A rare earth iron garnet single crystal film which is magnetically saturated by a weak field is therefore required.

Therefore, in such a magneto-optical sensor, a bismuth-substituted rare earth iron garnet single crystal film which becomes saturated at as low a field as possible from the viewpoints of performance and manufacturing cost, was much desired.

Rare earth iron garnet single crystal films having the chemical structural formula $R_3(FeA)_5O_{12}$, where R is yttrium Y or bismuth Bi, or a rare earth element, and A is aluminum Al, gallium Ga or the like, can be relatively easily manufactured by liquid phase epitaxy (LPE method). In particular, bismuth-substituted iron garnet single crystals wherein part of the rare earth is substituted by bismuth, show an extremely large Faraday effect, and are widely used as Faraday rotators for optical isolators.

As it is desirable for rare earth iron garnet single crystals used in optical switches and magneto-optical sensors to have as low a saturation magnetization as possible from the viewpoints of sensitivity and manufacturing cost, iron is often substituted by elements such as aluminum Al or gallium Ga. For example, $(GdBi)_3(FeGaAl)_5O_{12}$ or $(HoTbBi)_3(FeGaAl)_5O_{12}$ have been reported.

However, when the compositional proportion of Al, Ga and Fe is varied in a rare earth iron garnet single crystal film in an effort to lower the saturation magnetization, the magnetic hysteresis progressively increases which is a very serious problem in practical application.

Magnetic hysteresis will now be described, and the relation between external magnetic intensity and apparent Faraday rotation angle will be used as in Fig. 2 since it facilitates understanding.

A curve as shown in Fig. 2 can be used to show the magnetic characteristic of Faraday rotation angle relative to an external magnetic field of rare earth iron garnet single crystals having a high saturation magnetization, e.g. $(HoTbBi)_3Fe_5O_{12}$, i.e., the relation between external field intensity and apparent Faraday rotation angle.

However, in the case of rare earth substituted iron garnet single crystals having a low saturation magnetization, e.g. $(GdBi)_3(FeAlGa)_5O_{12}$, the relation between external field intensity and Faraday rotation angle is a hysteresis loop o-a-b-c-b'-a-o as shown in Fig. 3. This means that the path is different when the external field is strengthened (o-a-b-c) and when it is weakened (c-b-b'-a-o).

In other words, when the external field is weakened, although the material should assume a multi-domain structure as in state 2 in Fig. 1B and state 4 in Fig. 1D below the saturation magnetization, the structure of state 3 or 5 is perpetuated.

In Fig. 3, if the field at the points b and e is denoted by the saturation field Hs, and the field at the points b' and e' due to the hysteresis of magnetic properties is a nucleation field Hn, the difference Hs-Hn between the saturation field Hs and the nucleation field Hn defines the magnitude of the hysteresis. Now for simplicity and ease of explanation, let the saturation magnetization Hs at the point b be Hs1, the nucleation field Hn at the point b' be Hn1, the saturation magnetization Hs at the point e be Hs2, and the nucleation field Hn at the point e' be Hn2.

The term "nucleation" means that nuclei are formed when there is a change from a single domain structure to multiple domains.

As the hysteresis of the rare earth iron garnet single crystal film increases and the nucleation field Hn approaches the origin o, the magnetically saturated state is retained until the external field has almost decreased to zero as shown in Fig. 3. Therefore in optical rotating sensors comprising a Faraday rotator having a large hysteresis, the field intensity around the sensor must be effectively reduced to zero in order to detect the level of magnetic intensity.

However rotating sensors are normally inside mechanical devices and the materials of which these devices is constructed are magnetic, albeit slightly. It is therefore extremely difficult to reduce the magnetic field around the sensor to effectively zero before using it.

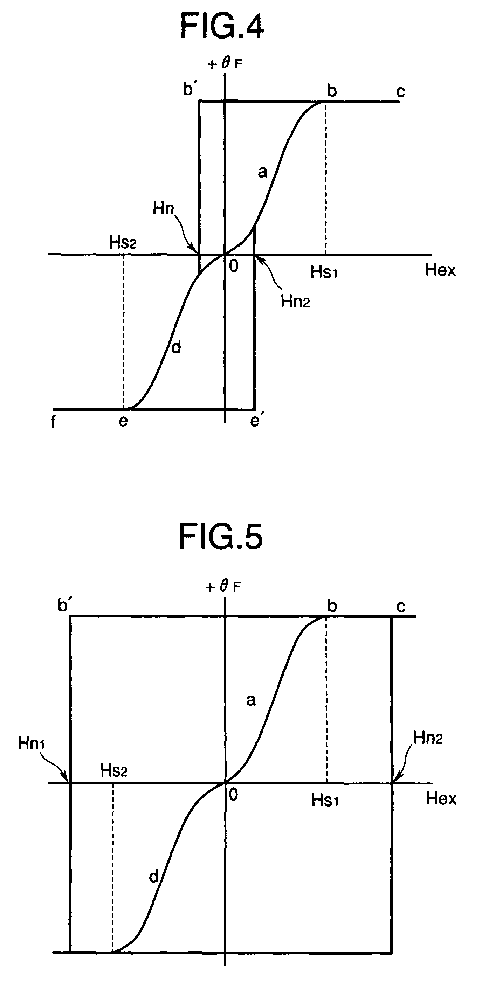

Also, when the hysteresis of the rare earth iron garnet single crystal film further increases, the nucleation field Hn1 may go beyond the origin o to the negative side (Fig. 4), or the nucleation field Hn1 may increase higher than the saturation magnetization Hs2 and draw a square hysteresis loop (Fig. 5). After saturation has been reached only the square loop is drawn, and in some cases the field required for saturation may even exceed the saturation magnetization Hs of the rare earth iron garnet single crystals.

Hence, rare earth iron garnet single crystal films having a low saturation magnetization also have a high magnetic hysteresis. When these films are used as Faraday rotators for optical switches and magneto-optical sensors, therefore, there are disadvantages and limitations in that a large field generator is required to change over the field, a strong permanent magnet must be attached to the rotating element, and the field observation area is extremely narrow.

SUMMARY OF THE INVENTION

When rare earth iron garnet single crystals are placed in an external field, they are magnetically saturated and therefore the multi-domain structure disappears and all the magnetism is aligned in one direction, i.e., single domain structure. As the external applied field is gradually weakened, the multi-domain structure appears when the magnetic intensity is slightly lower than the saturation field.

However, if a rare earth iron garnet single crystal film has a high hysteresis, then the material remains saturated retaining a single domain structure even when the applied external magnetic field is weakened. This is due to its high hysteresis.

An object of the invention is to provide a Faraday rotator (1) in which high magnetic hysteresis of rare earth iron garnet single crystals can effectively be reduced or substantially eliminated.

The aforementioned object can be achieved by a Faraday rotator (1) which includes two types (layers 1 and 2) of rare earth iron garnet single crystal film having different saturation magnetizations grown successively on a non-magnetic garnet substrate by liquid phase epitaxy such that one film is superposed on the other. The two types of rare earth iron garnet single crystal film include a main garnet film having a low saturation magnetization and an auxiliary garnet film having a high saturation magnetization. When the main garnet film is sufficiently saturated, the auxiliary garnet film is not saturated yet. When the external magnetic field is removed, the auxiliary garnet film which has not been saturated serves as a starting point or "nucleation" by which the magnetically saturated main garnet film can enter its non-saturation region showing a much decreased hysteresis.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

BRIEF DESCRIPTION OF THE DRAWINGS

The present invention will become more fully understood from the detailed description given hereinbelow and the accompanying drawings which are given by way of illustration only, and thus are not limitative of the present invention, and wherein:

Figs. 1A-1E are a model representation showing a magnetic domain structure of a rare earth iron garnet single crystal film, and one example of a change of magnetic domain structure due to an external magnetic field;

Fig. 2 is a diagram showing a change (Faraday loop), relative to external magnetic field intensity, of an apparent Faraday rotation angle of a rare earth iron garnet single crystal film not showing magnetic hysteresis;

Fig. 3 is a diagram showing a change (Faraday loop), relative to external magnetic field intensity, of an apparent Faraday rotation angle of a rare earth iron garnet single crystal film showing magnetic hysteresis;

Fig. 4 is a diagram showing a change (Faraday loop), relative to external magnetic field intensity, of an apparent Faraday rotation angle of a rare earth iron garnet single crystal film having a very large magnetic hysteresis;

Fig. 5 is a diagram showing a change (Faraday loop), relative to external magnetic field intensity, of an apparent Faraday rotation angle of a rare earth iron garnet single crystal film having an extremely large magnetic hysteresis;

Figs. 6A-6C are a model representation showing a variation of magnetic domain structure relative to an external magnetic field when a permanent magnet is affixed to one end of a rare earth iron garnet single crystal film having a very large magnetic hysteresis;

Figs. 7A-7C are a model representation showing a variation of the magnetic domain structures of rare earth iron garnet single crystal films having respectively high and low saturation magnetizations, when said film having a low saturation is grown on said film having a high saturation;

Fig. 8 is a model representation showing the construction of a reflecting magneto-optical sensor head fabricated in Example 6;

Fig. 9 is an intermediate state diagram for the purpose of describing a method of manufacturing light input/output parts of the reflecting magneto-optical sensor head fabricated in Example 6; and

Fig. 10 is a model representation showing the overall construction of the reflecting magneto-optical sensor head fabricated in Example 6.

DESCRIPTION OF THE INVENTION

The inventors carried out intensive studies to reduce magnetic hysteresis in rare earth iron garnet single crystal films having a low saturation magnetization.

As a result, they made the useful discovery that when a rare earth iron garnet single crystal film having a high saturation magnetization was grown by liquid phase epitaxy on or under a rare earth iron garnet single crystal film having a low saturation magnetization on a non-magnetic garnet substrate, the magnetic hysteresis of the rare earth iron garnet single crystal film of low saturation was greatly reduced, and after further experiments and trials, they arrived at the present invention.

The present invention is therefore a Faraday rotator characterized in comprising two types of rare earth iron garnet single crystal film having different saturation magnetizations grown successively on a non-magnetic garnet substrate by liquid phase epitaxy such that one film is superposed on the other. The difference in saturation magnetization between the two types of film differs by a factor of preferably at least two, and more preferably at least four. Also, of the two types of film, the saturation magnetization of the film having a high saturation magnetization is at least 400 Oe, the film having a low saturation magnetization contains bismuth, and the rare earth iron garnet single crystal films have a chemical composition represented by the following general formula:

$$R_{3-x}Bi_xFe_{5-y}A_yO_{12}$$

where R is at least one of Tb and Gd, A is at least one element chosen from Ga and Al, and x and y are numbers lying in the ranges of $0.7 \leqq x \leqq 1.9$ and $0.3 \leqq y \leqq 1.8$, respectively.

The Faraday rotator according to the present invention is also a magneto-optical sensor using a Faraday rotator comprising the aforesaid rare earth iron garnet single crystal film.

The inventors, after carrying out detailed investigation of the behavior of a rare earth iron garnet single crystal film with respect to an external magnetic field and its relation to magnetic domains, arrived at the present invention of which an account will now be given with reference to the events that led up to it.

As described above, when rare earth iron garnet single crystals are magnetically saturated, the magnetic domains disappear and all the magnetism is aligned in one direction (state 3 in Fig. 1A and state 5 in Fig. 1E).

As the external applied field is gradually weakened, when the magnetic intensity is slightly lower than the saturation field, magnetic domains appear, however even when the applied field is further weakened the rare earth iron garnet single crystal film, which has a high hysteresis, retains state 3 or state 5 which have a single magnetic domain structure.

It has been suggested that in order to change a single domain structure to a multi-domain structure, there must be a starting point where the domain structure changes over to the reverse direction, i.e., the negative direction of magnetization.

In view of this suggestion, the inventors considered attaching a permanent magnet to one end of a bismuth-substituted rare earth iron garnet single crystal film.

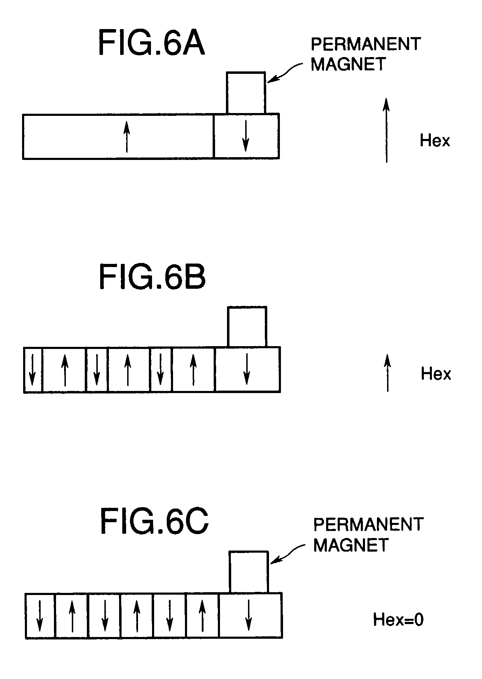

The film experiences a stronger external field only in the vicinity of the permanent magnet, and retains a magnetism in the reverse direction to that of the other parts of the bismuth-substituted film (Figs. 6A-6C). Therefore when the external field is removed, this area near the permanent magnet becomes a starting point, and magnetic domains having a reverse magnetization to that external field, are easily produced. In other words, a magnetic cycle as shown in Fig. 2 is followed.

However, to attach a permanent magnet to one end of a rare earth iron garnet single crystal film, the film must have a certain thickness, and there was thus a problem in making magnetic sensor heads using these films more compact.

The purpose of disposing a permanent magnet at one end of the rare earth iron garnet single crystal film is to retain magnetic domains having reverse magnetization in one part of the film.

The essential feature of this invention is to confer this ability on the film itself instead of using a permanent magnet.

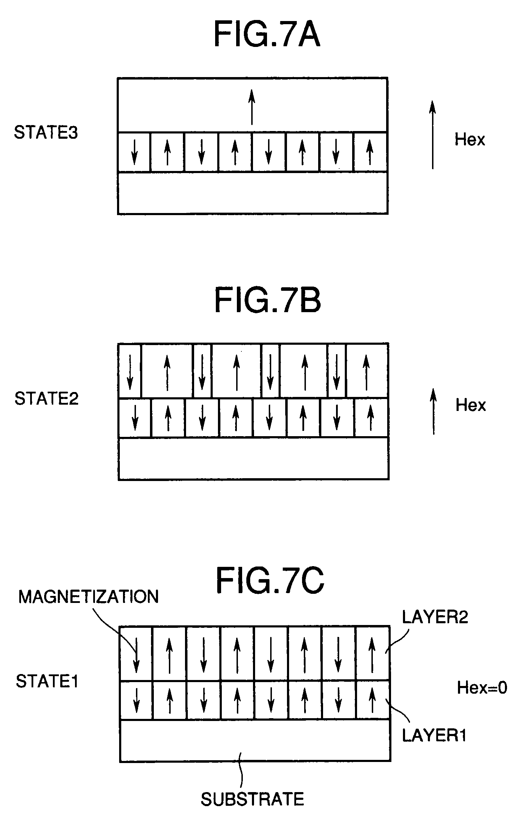

Figs. 7A-7C are an example of the construction of and magnetic domains in a rare earth iron garnet single crystal film for describing this invention.

Referring to Figs. 7A-7C, a garnet single crystal film grown on a substrate is referred to as layer 1, and a garnet single crystal film grown on layer 1 is referred to as layer 2. Layer 1 is a rare earth iron garnet single crystal film having a high saturation magnetization, and layer 2 is a rare earth iron garnet single crystal film having a low saturation magnetization. Layer 2 detects a magnetic field, and layer 1 reduces the magnetic hysteresis of layer 2. Therefore, herein, layer 2 will be abbreviated as main garnet film, while layer 1 will be abbreviated as auxiliary garnet film.

When no external magnetic field is applied, the magnetic domains are in state 1. Next, an external magnetic field Hex is applied, and as it is gradually increased, the width of the domains in the main film which are oriented upwards (in the positive direction) increases (state 2) so as to finally become a single domain (state 3).

On the other hand, due to its high saturation magnetization, the auxiliary film retains a multi-domain structure. Hence when the external magnetic field is removed, although the main film has a high magnetic hysteresis, the domains which have a negative magnetization in the multi-domain structure of the auxiliary film function as a starting point, and reverse magnetization easily occurs. In other words, it may be considered that the magnetic hysteresis has become smaller.

In the above description, layer 1 was taken as the auxiliary film and layer 2 was taken as the main film, however the effect of reducing the hysteresis of the main film is identical when layer 1 is the main film and layer 2 is the auxiliary film.

According to this invention, there is no particular limitation on the composition of the rare earth iron garnet single crystals comprising the main film, however as the main film has the role of detecting a magnetic field, a bismuth-substituted rare earth iron garnet single crystal film having a large Faraday effect, i.e., a high sensitivity, is desirable. A bismuth-substituted rare earth iron garnet single crystal film represented by the general formula:

$$R_{3-x}Bi_xFe_{5-y}A_yO_{12}$$

is preferred.

It is desirable that the saturation magnetization is as low as possible, preferably 300 0e or less and more preferably 200 0e or less. For this reason, it is preferred that the rare earth element R is at least one element chosen from Tb and Gd. It is moreover preferable that part of the iron is substituted by Ga or Al and that y is large, i.e., at least 0.7, to further lower the saturation magnetization. However when the substitution amount of Ga or Al increases, the Curie temperature decreases and the temperature range in which the film functions as a sensor becomes narrower, so y is preferably no greater than 1.8.

The Faraday effect of a bismuth-substituted rare earth iron garnet single crystal film effectively increases in direct proportion to the substitution amount x of bismuth, so x is preferably as large as possible. However when the bismuth substitution amount increases, defects increase, hence x is preferably no less than 0.7 and no greater than 1.9, and more preferably, no less than 1.0 and no greater than 1.6.

The role of the rare earth iron garnet single crystal film having a high saturation magnetization (auxiliary garnet film) is solely to maintain a multi-domain structure. In other words, it is necessary to constantly maintain an unsaturated state, and the film should therefore be as thin as possible. When the film is thick, light absorption and diffraction by the multiple domains increase, so the signal strength of the sensor declines.

However when the film becomes thin, its effect of suppressing the magnetic hysteresis of the main film decreases, so it is required to have a certain thickness. Specifically, the thickness may conveniently be chosen in the range of 4-20 $\mu$m.

When the saturation magnetization of the auxiliary garnet film is low, the magnetic hysteresis of the main garnet film is not improved, so a saturation magnetization of a certain magnitude is required. Specifically, the saturation magnetization of the auxiliary film should be twice or more that of the main film, more preferably four times or more and preferably no less than 400 Oe.

As a result of this invention, using rare earth iron garnet single crystal films, it is possible to manufacture compact optical switches with even more power saving, and magneto-optical sensors which can detect even minute fields.

EXAMPLES:

Some examples of this invention and their advantages will now be described in detail, but they should not be construed as limiting the invention or the scope of its application in any way.

Example 1

A double epitaxial film as a Faraday rotator for a magneto-optical sensor was produced by growing a main garnet film $Gd_{2.0}Bi_{1.0}Fe_{4.4}Ga_{0.1}Al_{0.5}O_{12}$ of 64 μm thickness (referred to hereafter as main garnet film 1) on an auxiliary garnet film $(HoTbBi)_3Fe_5O_{12}$ of 7 μm thickness (referred to hereafter as auxiliary garnet film 1).

First, the auxiliary garnet film 1 was fabricated as described below.

The following materials were placed in a platinum crucible of 500 ml capacity: 840 gm lead oxide (PbO, 4N), 980 gm bismuth oxide ($Bi_2O_3$, 4N), 130 gm ferric oxide ($Fe_2O_3$, 4N), 38 gm boric oxide ($B_2O_3$, 5N), 8.6 gm holmium oxide ($Ho_2O_3$, 3N) and 4.7 gm terbium oxide ($Tb_4O_7$, 3N).

The crucible was placed at a predetermined position in a precision vertical tubular electric furnace, and after melting the contents at 1,000°C and thoroughly blending them to give a homogeneous mixture, the contents were cooled to a melt temperature of 770°C so as to give a melt for growing bismuth-substituted rare earth iron garnet single crystals. This melt is hereafter referred to as "auxiliary garnet film melt 1".

One surface of a (111) garnet single crystal "$(GdCa)_3(GaMgZr)_5O_{12}$" substrate having a lattice constant of 1.2496±0.0002 nm (referred to hereafter as "SGGG substrate") of 1-in. diameter and thickness 480 μm was brought in contact by the usual method with the melt surface obtained as described above, and epitaxial growth was performed while maintaining the melt temperature of 770°C so as to obtain the $(HoTbBi)_3Fe_5O_{12}$ single crystal film of thickness 7 μm (auxiliary garnet film 1).

Next, the main garnet film 1 was prepared as described below.

The following materials were placed in a platinum crucible of 500 ml capacity: 840 gm lead oxide (PbO, 4N), 980 gm bismuth oxide ($Bi_2O_3$, 4N), 130 gm ferric oxide ($Fe_2O_3$, 4N), 36 gm boric oxide ($B_2O_3$, 5N), 15 gm

gadolinium oxide ($Gd_2O_3$, 3N), 2.6 gm gallium oxide ($Ga_2O_3$, 3N) and 7.6 gm aluminum oxide ($Al_2O_3$, 3N).

The crucible was placed at a predetermined position in a precision vertical tubular electric furnace, and after fusing the contents at 1,000°C and thoroughly blending them to give a homogeneous mixture, the contents were cooled to a melt temperature of 832°C so as to give a melt for growing bismuth-substituted rare earth iron garnet single crystals. This melt is hereafter referred to as "main garnet film melt 1".

The growth surface of the substrate on which the aforesaid auxiliary garnet film 1 had been grown, was brought in contact by the usual method with the surface of the melt obtained as described above, and epitaxial growth was performed while maintaining the melt temperature of 832°C so as to obtain the $Gd_{2.0}Bi_{1.0}Fe_{4.4}Ga_{0.1}Al_{0.5}O_{12}$ single crystal film of thickness 64 μm (main garnet film 1).

Magnetic properties were measured as follows.

Prior to epitaxially growing the main garnet film 1 on the auxiliary garnet film, a corner of the 1 inch substrate was cut off, and a test piece of size 3 mm x 3 mm was cut from this corner. An anti-reflection film was formed on both surfaces of the test piece, and the test piece was placed in the center of a magnetic field generator comprising a Helmholtz coil. While a magnetic field was applied to the test piece, it was irradiated with semiconductor laser light of wavelength 0.786 μm transmitted by a polarizer comprising a Glan-Thompson prism. The laser light that has passed through the test piece was received by an analyzer comprising a similar Glan-Thompson prism.

As the analyzer was rotated, the intensity of the light transmitted by the analyzer was measured. The apparent Faraday rotation angle was taken as the rotation angle of the analyzer when the optical intensity was a minimum. In this way, the applied field dependence of apparent Faraday rotation angle shown in Fig. 2 was obtained.

As a result, the saturation magnetization Hs of the auxiliary garnet film 1 was 980 Oe.

Magnetic measurements on the main garnet film 1 were performed in exactly the same way.

The obtained results were a saturation magnetization (Hs) of 83 Oe, nucleation field Hn of +63 Oe, and magnetic hysteresis Hs-Hn of 20 Oe.

Example 2

A double epitaxial film as a Faraday rotator for a magneto-optical sensor was produced by growing an auxiliary garnet film $(HoTbBi)_3Fe_5O_{12}$ of thickness 7 μm (referred to hereafter as auxiliary garnet film 2) on a main garnet film $Gd_{2.0}Bi_{1.0}Fe_{4.4}Ga_{0.1}Al_{0.5}O_{12}$ of 63 μm thickness (referred to hereafter as main garnet film 2).

First, the main garnet film 2 was fabricated as shown below.

Using the main garnet film melt 1 of Example 1, $Gd_{2.0}Bi_{1.0}Fe_{4.4}Ga_{0.1}Al_{0.5}O_{12}$ of 63 μm thickness was

grown on one surface of a 1-in. diameter SGGG substrate under exactly the same conditions as those of Example 1.

Next, the auxiliary garnet film 2 was grown on the main garnet film 2.

Using the auxiliary garnet film growth melt 1 of Example 1, $(HoTbBi)_3Fe_5O_{12}$ of thickness 7 $\mu$m was grown under exactly the same conditions used to grow the auxiliary garnet film 1.

The apparent magnetic properties of the auxiliary film 2 were then measured under exactly the same conditions as those of Example 1. The obtained results were a saturation magnetization Hs of 92 Oe, nucleation field Hn of +70 Oe, and magnetic hysteresis Hs-Hn of 22 Oe.

Example 3

A double epitaxial film as a Faraday rotator for a magneto-optical sensor was produced by growing a main garnet film $Tb_{1.8}Bi_{1.2}Fe_{4.2}Ga_{0.8}O_{12}$ of 75 $\mu$m thickness (referred to hereafter as main garnet film 3) on an auxiliary garnet film $(HoTbBi)_3(FeGaAl)_5O_{12}$ of 8 $\mu$m thickness (referred to hereafter as auxiliary garnet film 3).

First, the auxiliary garnet film 3 was fabricated as described below.

The following materials were placed in a platinum crucible of 500 ml capacity: 843 gm lead oxide (PbO, 4N), 978 gm bismuth oxide ($Bi_2O_3$, 4N), 128 gm ferric oxide ($Fe_2O_3$, 4N), 38 gm boric oxide ($B_2O_3$, 5N), 8.5 gm holmium oxide ($Ho_2O_3$, 3N), 5.1 gm terbium oxide ($Tb_4O_7$, 3N), 10 gm gallium oxide ($Ga_2O_3$, 3N) and 1.9 gm aluminum oxide ($Al_2O_3$, 3N).

The crucible was placed at a predetermined position in a precision vertical tubular electric furnace, and after melting the contents at 1,000°C and thoroughly blending them to give a homogeneous mixture, the contents were cooled to a melt temperature of 794°C so as to give a melt for growing bismuth-substituted rare earth iron garnet single crystals.

One surface of a 1-in. diameter SGGG substrate was brought in contact with the melt surface thus obtained, and epitaxial growth was performed by the usual method while maintaining a melt temperature of 782°C so as to obtain the $(HoTbBi)_3(FeGaAl)_5O_{12}$ single crystal film of 8 $\mu$m thickness.

The main garnet single crystal film 3 was produced as described below.

The following materials were placed in a platinum crucible of 500 ml capacity: 840 gm lead oxide (PbO, 4N), 980 gm bismuth oxide ($Bi_2O_3$, 4N), 130 gm ferric oxide ($Fe_2O_3$, 4N), 38 gm boric oxide ($B_2O_3$, 5N), 15.2 gm terbium oxide ($Tb_4O_7$, 3N) and 16.8 gm gallium oxide ($Ga_2O_3$, 3N).

The crucible was placed at a predetermined position in a precision vertical tubular electric furnace, and after fusing the contents at 1,000°C and thoroughly blending them to give a homogeneous mixture, the contents were cooled to a melt temperature of 804°C so as to give a melt for growing bismuth-substituted rare earth iron garnet single crystals. This melt is hereafter referred to as "main garnet film melt 3".

The growth surface of a substrate on which the aforesaid auxiliary garnet film 3 had been grown was brought in contact by the usual method with the surface of the melt thus obtained, and epitaxial growth was performed while maintaining the melt temperature of 804°C so as to obtain a $Tb_{1.8}Bi_{1.2}Fe_{4.2}Ga_{0.8}O_{12}$ single crystal film of thickness 75 $\mu$m (main garnet film 3).

Magnetic measurements were performed on the auxiliary garnet film 3 and main garnet film 3 exactly as in Example 1. As a result, the saturation magnetization of the auxiliary garnet film 3 was found to be 450 Oe.

The magnetic properties of the main garnet film 3 were a saturation magnetization Hs of 120 Oe, nucleation field Hn of +83 Oe, and magnetic hysteresis Hs-Hn of 37 Oe.

Example 4

A double epitaxial film as a Faraday rotator for a magneto-optical sensor was produced by growing a main garnet film $Gd_{2.0}Bi_{1.0}Fe_{4.4}Ga_{0.1}Al_{0.5}O_{12}$ of 69 $\mu$m thickness (referred to hereafter as main garnet film 4) on an auxiliary garnet film $(YLaBi)_3(FeGa)_5O_{12}$ of 10 $\mu$m thickness (referred to hereafter as auxiliary garnet film 4).

First, the auxiliary garnet film 4 was fabricated as described below.

The following materials were placed in a platinum crucible of 500 ml capacity: 843 gm lead oxide (PbO, 4N), 978 gm bismuth oxide ($Bi_2O_3$, 4N), 128 gm ferric oxide ($Fe_2O_3$, 4N), 48 gm boric oxide ($B_2O_3$, 5N), 6.4 gm yttrium oxide ($Y_2O_3$, 3N), 6.4 gm lanthanum oxide ($La_2O_3$, 3N) and 35 gm gallium oxide ($Ga_2O_3$, 3N) were introduced in a platinum crucible of 500 ml capacity.

The crucible was placed at a predetermined position in a precision vertical tubular electric furnace, and after melting the contents at 1,000°C and thoroughly blending them to give a homogeneous mixture, the contents were cooled to a melt temperature of 785°C so as to give a melt for growing bismuth-substituted rare earth iron garnet single crystals.

One surface of a 1-in. diameter SGGG substrate was brought in contact by the usual method with the surface of the melt obtained as described above, and epitaxial growth was performed while maintaining the melt temperature of 785°C so as to obtain the $(YLaBi)_3(FeGa)_5O_{12}$ single crystal film of thickness 10 $\mu$m (auxiliary garnet film 4).

Next, the growth surface of a substrate on which the auxiliary garnet film 4 had been grown was brought in contact with the main garnet film melt 1 under exactly the same conditions as the growth conditions for the main garnet film 1 in Example 1 so as to obtain the $Gd_{2.0}Bi_{1.0}Fe_{4.4}Ga_{0.1}Al_{0.5}O_{12}$ single crystal film of thickness 69 $\mu$m (main garnet film 4).

The magnetic properties of the auxiliary garnet film 4 and main garnet film 4 were measured exactly as in Example 1.

As a result, the saturation magnetization of the auxiliary garnet film 4 was 230 Oe, and the magnetic properties of the main garnet film 4 were a saturation magnetisation of 95 Oe, nucleation field of +45 Oe, and magnetic hysteresis of 50 Oe.

Example 5

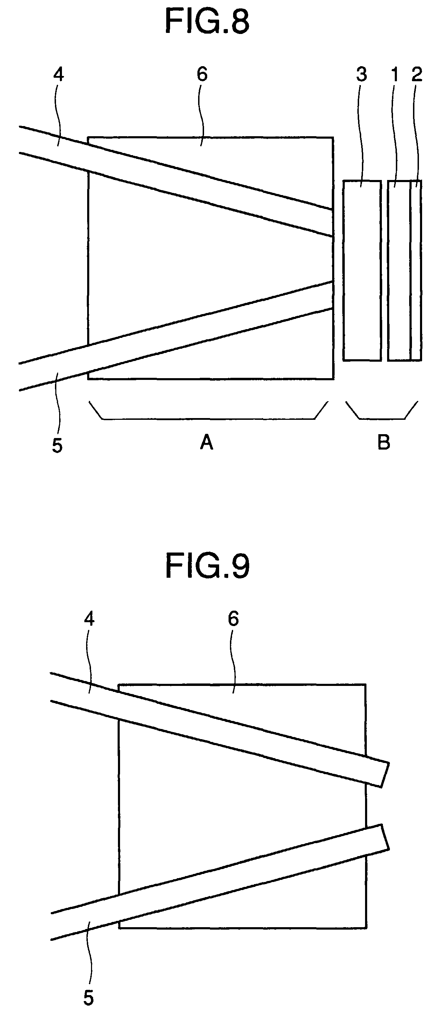

An example of a magneto-optical sensor according to this invention is shown in Fig. 8.

In Fig. 8, a Faraday rotator 1 is sandwiched between a polarizer 3 and a reflecting film 2 that serves as a reflector. Optical fibers 4 and 5 are mounted on a glass plate 6 which fixes and reinforces the optical fibers 4 and 5. One of the optical fibers 4 and 5 functions as a light input path and the other functions as a light output path.

The Faraday rotator 1 is fabricated by treating a double epitaxial film wherein the main garnet film 1 is grown on the auxiliary garnet film 1 obtained in Example 1, according to the following method.

After cutting out a Faraday rotator 1 of size 10mm x 10mm, the substrate side of this was polished according to the usual method to adjust the overall thickness to 200 $\mu$m. Next, a reflecting gold thin film 2 was used to cover the single crystal film side of the Faraday rotator, and an anti-reflection film having a center wavelength of 0.78 $\mu$m was used to cover the substrate side.

Next, the substrate side of the Faraday rotator and a dichroic polarizer of diameter 10 mm and thickness 200 $\mu$m (commercial name Polacore) were joined by an epoxy adhesive.

The combination of the Faraday rotator and dichroic polarizer obtained in this manner was cut to a size of 2 mm x 2 mm using a dicing machine so as to obtain a piece A shown in Fig. 8.

Using a dicing machine, two grooves of depth 300 $\mu$m and width 300 $\mu$m inclined to each other at an angle of 30 degrees, were cut on the surface of a glass plate of thickness 1 mm previously cut to a square shape of 4 mm x 4 mm (Fig. 9). Polymer-cladded quartz fibers 4 and 5 of outer diameter 230 $\mu$m and core diameter 200 $\mu$m were embedded in the grooves on the glass plate thus obtained, and fixed by epoxy adhesive (Fig. 9). Next, the ends of the optical fibers protruding from the edge of the glass plate (right side, Fig. 9) were removed by polishing so that they were flush with the surface, and the piece B shown in Fig. 8 was obtained.

The pieces A and B thus obtained were joined by epoxy adhesive so as to obtain a magneto-optical sensor head.

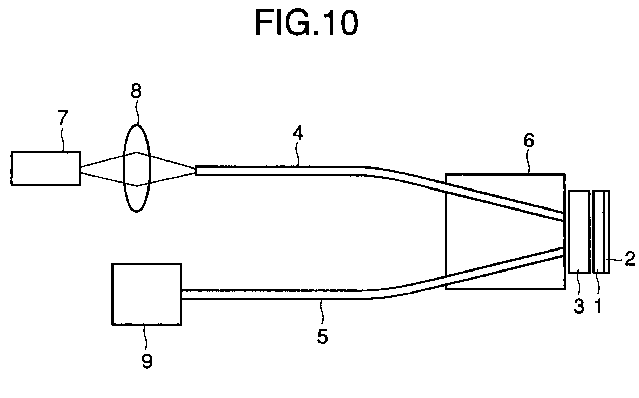

Using the magneto-optical sensor head thus obtained, a magneto-optical sensor system was constructed as shown in Fig. 10.

In this system, semiconductor laser light of wavelength 0.786 $\mu$m emitted by a semiconductor laser source 7 is guided via a lens 8 into the quartz fiber 4 (corresponding to the light input path). The laser light is transmitted to the sensor head, and passes through the polarizer 3 and Faraday rotator 1 in the head to reach the reflecting film 2.

Laser light reflected by the reflecting film 2 passes back through the polarizer 3 and Faraday rotator 1, and is guided via the optical fiber 5 (corresponding to the light output path) to a photodetector 9 where the light output is measured.

In practice a magnetic field of 100 Oe was applied to the part of the sensor head where the Faraday rotator is located, application of the magnetic field stopped 5 times, and measurements made.

Specifically, light of wavelength 0.786 $\mu$m was emitted by the light source 7, light of intensity -6 dBm caused to be incident on the sensor head from the optical fiber 4, and the intensity of the light returning to the optical fiber 5 was measured. As a result the intensity was -17.4 dBm when a magnetic field was not applied to the Faraday rotator, and -25.9 dBm when a magnetic field of 100 Oe was applied to the Faraday rotator so that it was magnetically saturated. In other words, a difference (signal-to-noise ratio, S/N) in light intensity between the incident light and reflected light return was 8.5 dB.

Comparative Example 1

The following epitaxial growth was performed using the main garnet film melt 1.

One surface of a 1-in. diameter SGGG substrate was brought in contact by the usual method with the surface of the main garnet melt 1, and epitaxial growth was performed while maintaining the melt temperature of 832°C so as to obtain a $Gd_{2.0}Bi_{1.0}Fe_{4.4}Ga_{0.1}Al_{0.5}O_{12}$ single crystal film of thickness 61 $\mu$m.

The magnetic properties were then measured in exactly the same way as in Example 1.

As a result, the magnetic properties of this garnet single crystal film were a saturation magnetization of 80 Oe, nucleation field of -22 Oe, and magnetic hysteresis of 122 Oe.

Comparative Example 2

Using the main garnet film melt 1 and auxiliary garnet film melt 1 of Example 1, an auxiliary garnet film $(HoTbBi)_3Fe_5O_{12}$ was grown and a main garnet film $Gd_{2.0}Bi_{1.0}Fe_{4.4}Ga_{0.1}Al_{0.5}O_{12}$ (referred to hereafter as "main garnet film 2C") of thickness 65 $\mu$m grown over it under exactly the same conditions as those of Example 1. The thickness of the auxiliary garnet film was 2 $\mu$m.

The magnetic properties were then measured in exactly the same way as in Example 1.

As a result, the magnetic properties of the main garnet film 2C were a saturation magnetization of 82 Oe, nucleation field of -4 Oe, and magnetic hysteresis of 86 Oe.

Comparative Example 3

The following epitaxial growth was performed using the main garnet film melt 3.

One surface of a 1-in. diameter SGGG substrate was brought in contact by the usual method with the surface of the main garnet melt 3, and epitaxial growth was performed while maintaining the melt temperature of 804°C so as to obtain a $Tb_{1.8}Bi_{1.2}Fe_{4.2}Ga_{0.8}O_{12}$ single crystal film of thickness 76 μm.

The magnetic properties were then measured in exactly the same way as in Example 1.

As a result, the magnetic properties of this garnet single crystal film were a saturation magnetization of 113 Oe, nucleation field of -47 Oe, and magnetic hysteresis of 160 Oe.

Comparative Example 4

The $Gd_{2.0}Bi_{1.0}Fe_{4.4}Ga_{0.1}Al_{0.5}O_{12}$ single crystal film obtained in Comparative Example 1 was used instead of the Faraday rotator used in Example 6, the other conditions being identical to those of Example 6, and the light intensity was measured.

As a result, the intensity was -24.3 dBm when a magnetic field was not applied to the Faraday rotator, and -24.6 dBm when a magnetic field of 100 Oe was applied to the Faraday rotator so that it was magnetically saturated. In other words, a difference (S/N) in light intensity between the incident light and the reflected light return was 0.3 dB.

This value is insufficient for use in a magneto-optical sensor.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

**Claims**

1. A Faraday rotator, comprising:

   a first film of rare earth iron garnet single crystal having a first saturation magnetization; and
   a second film of rare earth iron garnet single crystal having a second saturation magnetization; wherein
   said first and second films are grown one in contact with the other on a non-magnetic garnet substrate by an LPE method.

2. The Faraday rotator as defined in Claim 1, wherein said first and second saturation magnetizations differ by a factor of two.

3. The Faraday rotator as defined in Claim 1, wherein said first and second saturation magnetizations differ by a factor of four.

4. The Faraday rotator as defined in Claim 1, wherein one of said first and second saturation magnetizations is 400 Oe or more and is higher than the other.

5. The Faraday rotator as defined in Claim 1, wherein one of said first and second films contains bismuth and has a lower saturation magnetization than the other.

6. The Faraday rotator as defined in claim 5, wherein said first and second films have a chemical composition expressed by the following general formula:

$$R_{3-x}Bi_xFe_{5-y}A_yO_{12}$$

   where R is at least one element chosen from Tb and Gd, A is at least one element chosen from Ga and Al, and x and y are numbers lying in the ranges of $0.7 \leqq x \leqq 1.9$ and $0.3 \leqq y \leqq 1.8$, respectively.

7. The magneto-optical sensor incorporating a Faraday rotator as defined in Claim 1, the sensor further comprising:

   a light input path and light output path; and
   a polarizer (3) and a reflector (1) between which said Faraday rotator is held in a sandwiched relation; wherein
   light is incident on said Faraday rotator through said light input path via said polarizer (3) and is reflected by said reflector back through said Faraday rotator (1) and polarizer (3) into said light output path.

# FIG.1A

STATE3    ↑      ↑ Hex

# FIG.1B

STATE2    ↓ ↑ ↓ ↑ ↓ ↑ ↓ ↑      ↑ Hex

# FIG.1C

STATE1    ↓ ↑ ↓ ↑ ↓ ↑ ↓ ↑      Hex=0

DOMAIN A      DOMAIN B

# FIG.1D

STATE4    ↑ ↓ ↑ ↓ ↑ ↓ ↑ ↓      ↓ Hex

# FIG.1E

STATE5    ↓      ↓ Hex

EP 0 785 454 A1

# FIG.2

# FIG.3

12

# FIG.4

# FIG.5

## FIG.6A

PERMANENT
MAGNET

↑ Hex

## FIG.6B

↑ Hex

## FIG.6C

PERMANENT
MAGNET

Hex=0

# FIG.7A

STATE3

Hex

# FIG.7B

STATE2

Hex

# FIG.7C

MAGNETIZATION

LAYER2

STATE1

Hex=0

LAYER1

SUBSTRATE

# FIG.8

# FIG.9

# FIG.10

European Patent Office

**EUROPEAN SEARCH REPORT**

Application Number

EP 97 10 0469

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 338 859 A (MITSUBISHI GAS CHEMICAL CO) 25 October 1989 * claims 1,4,5 * | 1,5,6 | G02F1/00 G02F1/09 H01F10/08 H01F10/24 G01R33/032 |
| A | CHEMICAL ABSTRACTS, vol. 81, no. 18, 4 November 1974 Columbus, Ohio, US; abstract no. 112885w, UCHISHIBA ET AL: "Self-biasing effect of double layer epitaxial garnet films" page 499; column 2; XP002027581 * abstract * & FUJITSU SCI.TECH. J., vol. 10, no. 2, 1974, JP, pages 165-188, | 1-3 | |
| A | JAPANESE JOURNAL OF APPLIED PHYSICS, vol. 31, no. 6B, 15 June 1992, pages L790-L792, XP000323097 AKIYOSHI ITOH ET AL: "DOUBLE-LAYERED GARNET FILMS ON GLASS SUBSTRATE FOR HIGH CARRIER-TO-NOISE RATIO ON MAGNETOOPTICAL RECORDING" * page L790 * * page L792, column 2, paragraph 1 * | 1,2,5,7 | TECHNICAL FIELDS SEARCHED (Int.Cl.6) G02F H01F G01R |
| A | US 4 604 577 A (MATSUMURA HIROYOSHI ET AL) 5 August 1986 | | |
| P,X | US 5 566 017 A (SUZUKI TOSHIYASU ET AL) 15 October 1996 * column 4, line 20 - line 31; claim 4 * | 1,5,6 | |

The present search report has been drawn up for all claims

| Place of search | Date of completion of the search | Examiner |
|---|---|---|
| THE HAGUE | 17 March 1997 | Decanniere, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)